# EUROPÄISCHE PATENTSCHRIFT

(11) **EP 3 563 160 B1**
(45) Veröffentlichungstag und Bekanntmachung des Hinweises auf die Patenterteilung: **29.11.2023**
(21) Anmeldenummer: 17788126.5
(22) Anmeldetag: 04.10.2017
(51) Int. Cl.: G01R 31/58, G01R 1/04

(54) **ADAPTIERVORRICHTUNG, HALTEKLAMMER UND VERFAHREN ZUM POSITIONIEREN EINES LEITERPAARES EINES ZU MESSENDEN KABELS**
ADAPTER DEVICE, HOLDING CLAMP, AND METHOD FOR POSITIONING A CONDUCTOR PAIR OF A CABLE TO BE MEASURED
DISPOSITIF ADAPTATEUR, CLIP DE RETENUE ET PROCÉDÉ DE POSITIONNEMENT D'UNE PAIRE DE CONDUCTEURS D'UN CÂBLE À MESURER

(30) Priorität: 28.12.2016 DE 102016226261
(43) Veröffentlichungstag der Anmeldung: 06.11.2019
(73) Patentinhaber: BizLink Industry Germany GmbH, 91154 Roth (DE)
(72) Erfinder: GISKE, Nikolaj, 26169 Friesoythe (DE); BULIK, Kim-Thorben, 49191 Belm (DE); JANSSEN, Bernd, 26169 Friesoythe (DE)
(74) Vertreter: Frenkel, Matthias Alexander
(86) Internationale Anmeldenummer: PCT/EP2017/075179
(87) Internationale Veröffentlichungsnummer: WO 2018/121895

(56) Entgegenhaltungen:
- EP-A2- 2 703 826
- US-A- 3 462 682
- US-A- 3 913 425
- US-A- 4 647 844
- US-A- 4 961 357
- US-A- 5 138 910
- US-A1- 2005 050 713
- US-A1- 2015 207 241
- US-B1- 6 311 581
- US-B1- 6 330 839

## Beschreibung

Die vorliegende Offenbarung betrifft eine Adaptiervorrichtung, eine Halteklammer und ein Verfahren zum Positionieren eines Leiters, beispielsweise eines Leiterpaares, eines zu messenden Kabels.

Beim Messen von Kabeln, wie beispielsweise von Highspeed-Kabeln zum Übertragen von Signalen im Bereich von bis zu 50 GHz, ist die Probenvorbereitung eines zu messenden Kabels häufig mit einem hohen manuellen Aufwand verbunden und nimmt daher vergleichsweise viel Zeit in Anspruch. Bevor eine Messung durchgeführt werden kann muss zum Beispiel die Isolierung der zu messenden Leiter des Kabels abschnittsweise entfernt werden. Ferner muss eventuell die Länge der abisolierten Abschnitte der Leiter angepasst werden, um eine optimale Kontaktierung mit einer mit einem Messgerät verbindbaren Leiterplatte sicherzustellen. Des Weiteren müssen die präparierten Leiter auf der Leiterplatte positioniert und an dieser fixiert werden. Das teure Messgerät kann während der Probenvorbereitung meist nicht verwendet werden.

In der Praxis wird die Probenvorbereitung herkömmlicherweise manuell per Hand durchgeführt. Dies führt jedoch zu relativ großen Unterschieden zwischen verschiedenen Messungen und hat daher negative Auswirkungen auf die Reproduzierbarkeit von Messergebnissen. Zum einen unterscheiden sich durch die manuelle Vorbereitung die verschiedenen Proben bzw. die vorbereiteten, zu messenden Kabel voneinander, beispielsweise hinsichtlich der Länge des abisolierten Abschnitts des Leiters. Zum anderen variiert zwischen verschiedenen Messungen beispielsweise die Kontaktierung des zu messenden Leiters mit der Leiterplatte.

US 4 647 844 A offenbart eine Testvorrichtung für ein Kabel, umfassend eine Fixierstruktur. Die Fixierstruktur weist ein unteres Fixierteil und ein oberes Fixierteil auf, die über eine ihrer Kanten mit einem Scharnier miteinander gekoppelt und damit zueinander verschwenkbar angeordnet sind. In beiden Fixierteilen ist parallel zu der Anordnung des Scharniers eine Ausnehmung zur Aufnahme des Kabels ausgebildet.

US 3 462 682 A offenbart eine Prüfvorrichtung umfassend eine untere schachtelförmige Aufnahmehälfte und eine obere schachtelförmige Aufnahmehälfte. Beide Aufnahmehälften sind mit einem Scharnier zueinander verschwenkbar gekoppelt und weisen jeweils an gegenüberliegenden Seitenwänden eine Ausnehmung zur Aufnahme eines zu prüfenden Kabels auf.

US 2015 / 207 241 A1 offenbart eine Vorrichtung zum mechanischen Fixieren eines Kabels, umfassend ein unteres Fixierteil und ein oberes Fixierteil, die über ein Gelenk miteinander gekoppelt und zueinander verschwenkbar angeordnet sind.

EP 2 703 826 A2 offenbart eine Messzange, umfassend eine Halterung mit einem geradlinig angeordneten Kabel. Die Halterung weist eine Bohrung zur Aufnahme des Kabels auf. Eine Fixierschraube ist in ein Gewinde der Halterung quer zu der Bohrung eingeschraubt und dazu eingerichtet, das in die Rille eingelegte Kabel zu klemmen.

US 5 138 910 A und US 3 913 425 A offenbaren jeweils Adaptiervorrichtungen gemäß dem Oberbegriff von Anspruch 1. Die Druckschriften US 6 311 581 B1, US 2005 / 050 713 A1, US 6 330 839 B1 und US 4 961 357 A betreffen weiteren Stand der Technik.

Es ist eine Aufgabe der vorliegenden Erfindung, das Messen eines Leiters eines Kabels zu vereinfachen und die Reproduzierbarkeit von Kabelmessungen zu verbessern.

Diese Aufgabe wird durch eine Adaptiervorrichtung mit den Merkmalen des Anspruchs 1, eine Halteklammer mit den Merkmalen des Anspruchs 7 und ein Verfahren mit den Merkmalen des Anspruchs 12 gelöst.

Weitere Ausführungsformen werden aus den abhängigen Ansprüchen 2 bis 6 und 8 bis 11 sowie der nachfolgenden Beschreibung ersichtlich.

Gemäß einem ersten Aspekt ist eine Adaptiervorrichtung zum Positionieren wenigstens eines Leiters gemäß Anspruch 1 angegeben.

Mit anderen Worten dient die Adaptiervorrichtung der Probenvorbereitung wenigstens eines Leiters oder wenigstens eines Leiterpaares eines zu messenden Kabels, indem die Position und Ausrichtung des Leiters oder Leiterpaares mittels der Adaptiervorrichtung in einer vorbestimmten Weise und damit reproduzierbar festgelegt werden kann. Während die Halteklammer fest oder austauschbar an der Aufnahmeeinrichtung anbringbar ist, kann die Aufnahmeeinrichtung beispielsweise an einem Untergrund, einem Gestell oder einer weiteren Komponente der Adaptiervorrichtung stationär montierbar oder montiert sein. Da der mittels der Halteklammer aufgenommene und geklemmte wenigstens eine Leiter durch das Anbringen der Halteklammer an der Aufnahmeeinrichtung auch relativ zu dieser Aufnahmeeinrichtung fixiert ist, kann gleichzeitig auch dessen Position relativ zu weiteren Komponenten der Adaptiervorrichtung und/oder weiteren mit der Adaptiervorrichtung verbindbaren Vorrichtungen festgelegt werden.

Die Halteklammer kann beispielsweise lösbar an der Aufnahmeeinrichtung anbringbar sein. Die Halteklammer ist fest an der Aufnahmeeinrichtung angebracht. So kann die Halteklammer beispielsweise über ein Schienensystem an der Aufnahmeeinrichtung befestigt und über dieses Schienensystem relativ zu der Aufnahmeeinrichtung bewegbar sein.

In einer beispielhaften Ausführungsform kann die Halteklammer an der Aufnahmeeinrichtung anbringbar sein, wobei die Aufnahmeeinrichtung über ein Schienensystem verschiebbar am Untergrund befestigt sein kann.

Die Aufnahmeeinrichtung und die Halteklammer der Adaptiervorrichtung können zumindest abschnittsweise eine zueinander komplementäre Gestalt aufweisen, um die Halteklammer formschlüssig an der Aufnahmeeinrichtung anzubringen. Auch kann beispielsweise vorgesehen sein, dass die Halteklammer und die Aufnahmeeinrichtung durch das Anbringen der Halteklammer an der Aufnahmeeinrichtung miteinander eine lösbare Rastverbindung ausbilden. Alternativ oder zusätzlich zu einer formschlüssigen Verbindung der Halteklammer mit der Aufnahmeeinrichtung können Mittel an der Halteklammer und/oder der Aufnahmeeinrichtung vorgesehen sein, um die Halteklammer kraftschlüssig mit der Aufnahmeeinrichtung zu verbinden.

In einer Ausführungsform kann die Aufnahmeeinrichtung einen Aufnahmekörper mit einer Aufnahmeausnehmung aufweisen, durch die sich die Halteklammer in einem an der Aufnahmeeinrichtung angebrachten Zustand hindurch erstreckt, so dass die Halteklammer den Aufnahmekörper an einander entgegengesetzten Seiten des Aufnahmekörpers überragt.

Die Aufnahmeausnehmung der Aufnahmeeinrichtung kann einen Innenumfang aufweisen, der mit einem Außenumfang der Halteklammer zumindest abschnittsweise in Eingriff bringbar ist. In diesem Fall können die Innenumfangsfläche der Aufnahmeausnehmung und die Außenumfangsfläche der Halteklammer zumindest abschnittsweise komplementär zueinander ausgebildet sein. Die von dem Innenumfang der Aufnahmeausnehmung gebildete Querschnittsöffnung und der Querschnitt der Halteklammer können zum Beispiel rechteckiger Form sein. In einem montierten Zustand kann die Innenumfangsfläche der Aufnahmeausnehmung die Außenumfangsfläche der Halteklammer teilweise oder vollständig umschließen.

Die Adaptiervorrichtung umfasst eine mit der Aufnahmeeinrichtung verbundene Schneid- und Abisoliereinrichtung. Die Schneid- und Abisoliereinrichtung kann ein Schneidwerkzeug aufweisen, das dazu ausgebildet ist, den sich über die Halteklammer hinaus erstreckenden Endabschnitt des wenigstens einen von der Halteklammer aufgenommenen und geklemmten Leiters auf eine vorbestimmte Länge zuzuschneiden. Alternativ oder zusätzlich dazu kann die Schneid- und Abisoliereinrichtung ein Abisolierwerkzeug aufweisen, das dazu ausgebildet ist, einen vorbestimmten Bereich des sich über die Halteklammer hinaus erstreckenden Endabschnitts des wenigstens einen von der Halteklammer aufgenommenen und geklemmten Leiters abzuisolieren.

Die Position der Schneid- und Abisoliereinrichtung relativ zu der Aufnahmeeinrichtung kann festgelegt sein, indem diese aneinander fixierbar ausgebildet sind oder indem die Aufnahmeeinrichtung in der Schneid- und Abisoliereinrichtung integriert ist. Die Aufnahmeeinrichtung kann verlagerbar an der Schneid- und Abisoliereinrichtung montiert und in verschiedenen Positionen relativ zu der Schneid- und Abisoliereinrichtung fixierbar sein. Auch kann die Halteklammer im Falle einer in der Schneid- und Abisoliereinrichtung integrierten Aufnahmeeinrichtung, die nicht relativ zu der Schneid- und Abisoliereinrichtung verlagerbar ist, in der Aufnahmeeinrichtung verlagerbar und in verschiedenen Positionen an dieser anbringbar, d.h. relativ zu dieser fixierbar, sein. In dem letztgenannten Ausführungsbeispiel gilt die Halteklammer erst dann als an der Aufnahmeeinrichtung angebracht, wenn sie gegenüber dieser fixiert und demnach in ihrer Lage und Ausrichtung relativ zu dieser festgelegt ist. Somit kann der mittels der Halteklammer und der Aufnahmeeinrichtung positionierte wenigstens eine Leiter gleichzeitig in den verschiedenen Ausführungsformen in seiner Lage und Ausrichtung relativ zu der Schneid- und Abisoliereinrichtung ausgerichtet und fixiert werden.

Die Schneid- und Abisoliereinrichtung kann automatisch betreibbar sein und kann somit automatisch den sich über die Halteklammer hinaus erstreckenden Endabschnitt des wenigstens einen Leiters in einem vorbestimmten Bereich abisolieren und/oder den Endabschnitt, genauer gesagt den abisolierten Bereich des Endabschnitts, auf eine vorbestimmte Länge zuschneiden. Das Zuschneiden und Abisolieren kann in einer beliebigen Reihenfolge durchgeführt werden. Dadurch können die gesamte Länge des Endabschnitts, d.h. die Länge des über die Halteklammer hinaus stehenden wenigstens einen Leiters, die Länge des abisolierten Bereichs des Endabschnitts und die Länge des weiterhin isolierten Bereichs des Endabschnitts präzise vorbereitet werden. Somit kann durch die festgelegte Positionierung des wenigstens einen Leiters und das automatische Zuschneiden und Abisolieren eine reproduzierbare Probenvorbereitung sichergestellt werden.

Die Adaptiervorrichtung kann in einer Ausführungsform einen mit einem Messgerät verbindbaren Messadapter umfassen, der eine Leiterplatte mit einem Kontaktbereich zum Kontaktieren des Endabschnitts des wenigstens einen Leiters und einen verlagerbaren Stempel aufweist. Der verlagerbare Stempel kann dazu ausgebildet sein, durch Betätigung den Endabschnitt des wenigstens einen Leiters auf den Kontaktbereich der Leiterplatte zu drücken. Der verlagerbare Stempel kann beispielsweise automatisch betätigbar sein. Die Position einer Basis des Messadapters relativ zu der Aufnahmeeinrichtung kann festgelegt sein. Somit kann der mittels der Halteklammer und der Aufnahmeeinrichtung positionierte wenigstens eine Leiter gleichzeitig in seiner Lage und Ausrichtung relativ zu der Basis des Messadapters fixiert sein.

Der Messadapter kann einen X-Y-Tisch umfassen, wobei die Leiterplatte des Messadapters auf dem X-Y-Tisch mit Mikrometerschrauben montiert sein kann. Dabei kann die Lage der Leiterplatte relativ zu dem Endabschnitt des wenigstens einen Leiters durch Einstellen der Mikrometerschrauben anpassbar sein. Eine Halteeinrichtung des Stempels kann in ihrer Lage relativ zu der Leiterplatte fixiert sein, so dass der Stempel durch Einstellen der Mikrometerschrauben gemeinsam mit der Leiterplatte verlagerbar ist. Da die Position des wenigstens einen Leiters bzw. dessen Endabschnitts mittels der Halteklammer und der Aufnahmeeinrichtung relativ zu den Messadapter fixiert ist und die Lage der Leiterplatte relativ zu dem Endabschnitt des wenigstens einen Leiters präzise einstellbar ist, kann eine reproduzierbare Kontaktierung zwischen dem abisolierten Bereich des Endabschnitts des wenigstens einen Leiters und der Leiterplatte erreicht werden.

Gemäß einer Ausführungsform kann die Adaptiervorrichtung eine weitere Aufnahmeeinrichtung und eine an der weiteren Aufnahmeeinrichtung anbringbare weitere Halteklammer umfassen. Die weitere Aufnahmeeinrichtung und die weitere Halteklammer können die gleichen Merkmale wie die vorstehend beschriebene Aufnahmeeinrichtung bzw. Halteklammer aufweisen. In dieser Ausführungsform kann ein Ende des zu messenden Kabels mittels der Aufnahmeeinrichtung und der Halteklammer positioniert werden, während das andere Ende des zu messenden Kabels mittels der weiteren Aufnahmeeinrichtung und der weiteren Halteklammer positioniert wird.

Ein weiterer Aspekt betrifft eine Halteklammer gemäß Anspruch 7. Mit anderen Worten dient die Halteklammer der Probenvorbereitung wenigstens eines Leiters oder wenigstens eines Leiterpaares eines zu messenden Kabels, indem die Position und Ausrichtung des Leiters oder Leiterpaares mittels der Halteklammer in einer vorbestimmten Weise und damit reproduzierbar festgelegt werden kann. Dazu kann die Halteklammer austauschbar und in ihrer Lage und Ausrichtung fixierbar an einer Aufnahmeeinrichtung, beispielsweise einer Aufnahmeeinrichtung der vorstehend beschriebenen Art, anbringbar sein.

In einer Ausführungsform kann die Halteklammer einen länglichen Grundkörper aufweisen, der einen ersten Schenkel und einen zweiten Schenkel umfasst, die sich entlang einer Längsachse der Halteklammer im Wesentlichen parallel zueinander erstrecken und voneinander beabstandet sind, um den wenigstens einen Leiter zumindest abschnittsweise zwischen dem ersten und dem zweiten Schenkel aufzunehmen. Dazu können die Schenkel beispielsweise an einer dem jeweils anderen Schenkel zugewandten Fläche eine Nut aufweisen, die sich in Längsrichtung der Halteklammer erstreckt und dazu ausgebildet ist, einen Abschnitt des wenigstens einen Leiters mit oder ohne zugehöriger Isolierung aufzunehmen.

Der erste Schenkel und der zweite Schenkel können zumindest abschnittsweise relativ zueinander, zumindest geringfügig, verlagerbar sein. Jeder der beiden Schenkel kann eine Federvorspannung haben, die einer Verlagerung des jeweiligen Schenkels entgegenwirkt. Der erste und/oder der zweite Schenkel kann einen Vorsprung aufweisen, der sich in Richtung des jeweils anderen Schenkels erstreckt und dazu ausgebildet ist, auf den wenigstens einen Leiter einzuwirken, um diesen zwischen dem Vorsprung und dem jeweils anderen Schenkel zu klemmen. Der Vorsprung kann zum Beispiel an der die Nut aufweisenden Fläche des ersten und/oder zweiten Schenkels ausgebildet sein. Wird eine Kraft auf den ersten und den zweiten Schenkel aufgebracht, die die Schenkel aufeinander zu bewegt bzw. zusammendrückt, kann der zwischen diesen angeordnete wenigstens eine Leiter durch die einander zugewandten Flächen und durch den Vorsprung oder die Vorsprünge in der Halteklammer festgeklemmt werden.

Die Dimensionen und Geometrien der Schenkel sowie der zwischen diesen vorgesehene Abstand kann so gewählt sein, dass die Halteklammer mit unterschiedlichen Kabeln und Leitern verschiedener Geometrien und Dimensionen verwendbar ist. Alternativ dazu können die Dimensionen und Geometrien der Schenkel sowie der zwischen diesen vorgesehene Abstand der Halteklammer zum Aufnehmen und Klemmen einer oder mehrerer bestimmter Produktausführungen gewählt sein. Die Halteklammer ist somit für eine Vielzahl von Messungen wiederverwendbar.

In einer Weiterbildung der Halteklammer können der erste Schenkel und der zweite Schenkel an einem Ende der Halteklammer, beispielsweise schwenkbar, miteinander verbunden sein, wobei die Halteklammer an diesem Ende eine Einführöffnung zum Einführen des wenigstens einen Leiters umfasst. Die Halteklammer kann zum Beispiel einstückig sein oder separat voneinander ausgebildete erste und zweite Schenkel umfassen.

Die Halteklammer umfasst einen Kraftaufbringungsmechanismus**,** der dazu ausgebildet ist, auf den ersten und/oder den zweiten Schenkel einzuwirken, um den wenigstens einen Leiter fest zwischen dem ersten und dem zweiten Schenkel zu klemmen. Der Kraftaufbringungsmechanismus bringt eine Kraft auf den ersten und den zweiten Schenkel auf, die die Schenkel aufeinander zu bewegt bzw. zusammendrückt, um den zwischen diesen angeordneten wenigstens einen Leiter festzuklemmen. Hierzu kann der Kraftaufbringungsmechanismus manuell oder automatisch einstellbar sein.

Der Kraftaufbringungsmechanismus umfasst einen im Wesentlichen U-förmigen Bügel mit zwei zueinander parallelen Bügelschenkeln und einem die Bügelschenkel verbindenden Bügelsteg, wobei die Bügelschenkel jeweils fest oder schwenkbar mit dem zweiten Schenkel der Halteklammer verbunden sind und der erste Schenkel der Halteklammer zwischen dem Bügelsteg und dem zweiten Schenkel angeordnet ist. Der Bügelsteg kann eine Gewindebohrung aufweisen, in die eine Schraube einschraubbar ist, um auf den ersten Schenkel der Halteklammer kraftaufbringend einzuwirken.

Der Grundkörper der Halteklammer kann mittels eines Rapid-Prototyping-Verfahrens, beispielsweise mittels eines 3D-Druck-Verfahrens, herstellbar sein. Der Grundkörper kann aus Kunststoff gebildet sein, während der Kraftaufbringungsmechanismus metallischen Materials sein kann.

Die Halteklammer kann vergleichsweise einfach austauschbar an der Aufnahmeeinrichtung anbringbar sein. Dies ermöglicht ein Verwenden der Halteklammer mit verschiedenen Messadaptern, Messgeräten und/oder Leitern, wodurch eine schnelle und reproduzierbare Kontaktierung des wenigstens einen Leiters mit einer Leiterplatte und somit eine schnelle und reproduzierbare Messdurchführung erreicht werden kann.

Es versteht sich, dass die Halteklammer mit einem oder mehreren der vorstehend beschriebenen Merkmale auch in einer Adaptiervorrichtung der oben beschriebenen Art vorgesehen sein kann.

In einem weiteren Aspekt ist ein Verfahren zum Positionieren wenigstens eines Leiters eines zu messenden Kabels gemäß Anspruch 12 angegeben.

Es versteht sich, dass der Gegenstand der Offenbarung nicht auf die zuvor beschriebenen Aspekte, Ausführungsformen und Weiterbildungen beschränkt ist. Die beschriebenen Merkmale können vom Fachmann beliebig kombiniert werden, ohne dabei vom Gegenstand der Offenbarung abzuweichen.

Beispielhafte Ausführungsformen werden nachfolgend anhand der beigefügten, schematischen Zeichnungen näher erläutert. Es stellen dar:
- Figur 1: ein Ausführungsbeispiel der Adaptiervorrichtung in einem Zustand zu Beginn einer Anbringung einer Halteklammer an einer Aufnahmeeinrichtung;
- Figur 2: das Ausführungsbeispiel der Adaptiervorrichtung gemäß Figur 1 in einem Zustand am Ende der Anbringung der Halteklammer an der Aufnahmeeinrichtung;
- Figur 3: das Ausführungsbeispiel der Adaptiervorrichtung gemäß Figur 1 in einer weiteren Ansicht;
- Figur 4: ein weiteres Ausführungsbeispiel einer Adaptiervorrichtung mit einer Schneid- und Abisoliereinrichtung;
- Figur 5: ein weiteres Ausführungsbeispiel einer Adaptiervorrichtung zum Positionieren beider Enden eines zu messenden Kabels;
- Figur 6: ein Ausführungsbeispiel einer Haltklammer in einer Seitenansicht;
- Figur 7: ein Ausführungsbeispiel der Haltklammer gemäß Figur 6 in einer Untersicht; und
- Figur 8: ein Ausführungsbeispiel der Haltklammer gemäß Figur 6 mit einem darin aufgenommenen und geklemmten Leiter in einer Seitenansicht;
- Figuren 9A bis 9I: ein Beispiel eines Schneid- und Abisoliervorgangs mittels einer Schneid- und Abisoliereinrichtung der Adaptiervorrichtung gemäß Figur 4.

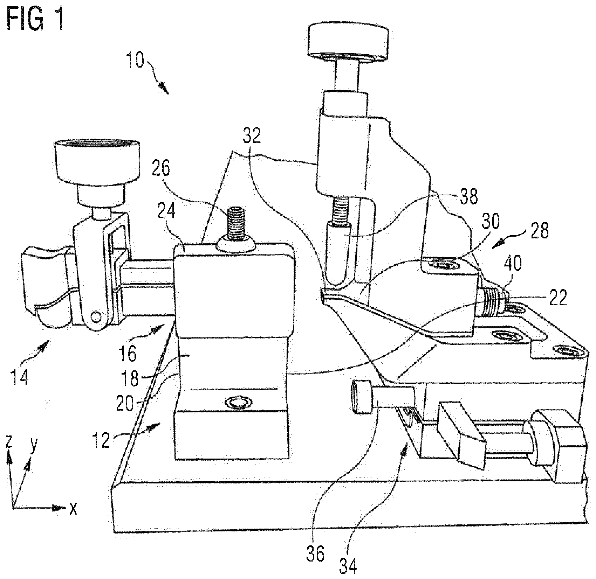

Figur 1 zeigt eine Adaptiervorrichtung 10 mit einer Aufnahmeeinrichtung 12 und einer lösbar an der Aufnahmeeinrichtung 12 anbringbaren Halteklammer 14. Zur Anbringung der Halteklammer 14 an der Aufnahmeeinrichtung 12 ist die Halteklammer 14 in einer Aufnahmeausnehmung 16 eines Aufnahmekörpers 18 der Aufnahmeeinrichtung 12 aufnehmbar. Die Aufnahmeausnehmung 16 erstreckt sich in diesem Ausführungsbeispiel von einer seitlichen Stirnfläche 20 des Aufnahmekörpers 18 im Wesentlichen horizontal durch diesen hindurch bis zu einer der seitlichen Stirnfläche 20 entgegengesetzten weiteren seitlichen Stirnfläche 22. Somit bildet die Aufnahmeausnehmung 16 an beiden Stirnflächen 20, 22 eine Aufnahmeöffnung (in Figur 1 nicht gezeigt). Es versteht sich, dass die Halteklammer in einem weiteren Ausführungsbeispiel fest an der Aufnahmeeinrichtung angebracht sein kann. Beispielsweise kann die Halteklammer über ein Schienensystem mit der Aufnahmeeinrichtung verbunden und relativ zu dieser verschiebbar sein.

Der Aufnahmekörper 18 der Aufnahmeeinrichtung 12 ist in dem gezeigten Beispiel fest mit dem Untergrund verbunden, beispielsweise über eine Schraub- oder Klebeverbindung, wodurch die Aufnahmeeinrichtung 12 in ihrer Lage und Ausrichtung fixiert ist. In einem nicht gezeigten weiteren Beispiel kann der Aufnahmekörper über ein Schienensystem mit dem Untergrund verbunden und relativ zum Untergrund verschiebbar sein. An einer dem Untergrund entgegengesetzten oberen Fläche 24 weist die Aufnahmeeinrichtung 12 eine Gewindeschraube 26 auf, um die Aufnahmeeinrichtung 12 beispielsweise mit weiteren Komponenten der Adaptiervorrichtung 10 fest zu verbinden.

In dem in Figur 1 gezeigten Zustand zu Beginn einer Anbringung der Halteklammer 14 an der Aufnahmeeinrichtung 12 ist die Halteklammer 14 lediglich teilweise in der Aufnahmeausnehmung 16 aufgenommen und somit noch nicht vollständig in ihrer Lage und Ausrichtung relativ zu der Aufnahmeeinrichtung 12 festgelegt. Zum vollständigen Festlegen der Lage und Ausrichtung der Halteklammer 14 relativ zu der Aufnahmeeinrichtung 12 ist die Halteklammer 14 weiter in Richtung der Längsachse der Halteklammer 14 bzw. der Aufnahmeausnehmung 16 in die Aufnahmeausnehmung 16 einbringbar.

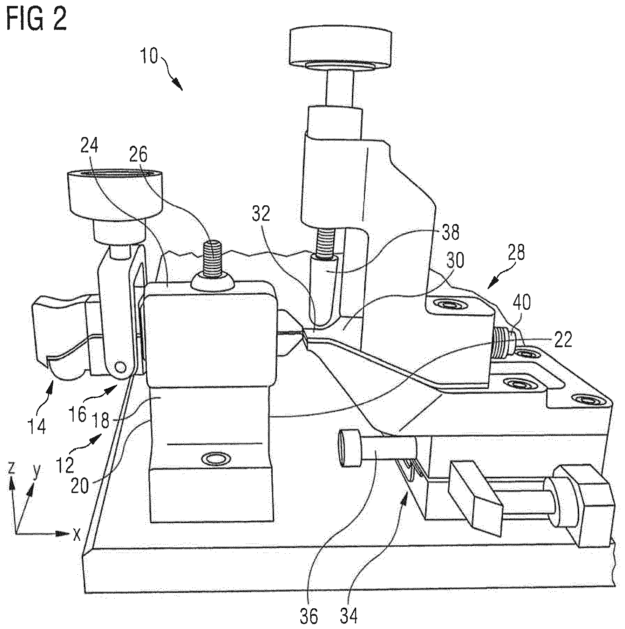

Der Zustand am Ende der Anbringung der Halteklammer 14 an der Aufnahmeeinrichtung 12, in dem die Halteklammer 14 in ihrer Lage und Ausrichtung relativ zu der Aufnahmeeinrichtung 12 und somit relativ zu dem Untergrund festgelegt ist, ist in Figur 2 dargestellt. In diesem Zustand erstreckt sich die Halteklammer 14 durch die Aufnahmeausnehmung 16 der Aufnahmeeinrichtung 12 hindurch, sodass sie den Aufnahmekörper an den zwei einander entgegengesetzten Stirnflächen 20, 22 überragt.

Die Figuren 1 und 2 zeigen ferner einen Messadapter 28 der Adaptiervorrichtung 10, der eine Leiterplatte 30 mit einem Kontaktbereich 32 umfasst. Die Leiterplatte 30 ist auf einem X-Y-Tisch 34 des Messadapters 28 montiert. Über Mikrometerschrauben 36 ist die Position der Leiterplatte 30 und des Kontaktbereichs 32 relativ zu der Aufnahmeeinrichtung 12 präzise einstellbar. Der Messadapter 28 umfasst ferner einen Stempel 38, der in vertikaler Richtung oberhalb des Kontaktbereichs 32 der Leiterplatte 30 verlagerbar angeordnet ist. Der Stempel 38 ist über eine Halteeinrichtung 40 fest mit der Leiterplatte 30 und dem X-Y-Tisch 34 verbunden und wird durch Einstellen der Mikrometerschrauben 36 gemeinsam mit der Leiterplatte 30 bewegt. Mit anderen Worten ist der Stempel 38 in seiner Ausrichtung in X- und Y-Richtung relativ zu der Leiterplatte 30 festgelegt. In Z-Richtung ist der Stempel 38 relativ zu der Leiterplatte 30, genauer gesagt dem Kontaktbereich 32, manuell verlagerbar. Zum Durchführen einer Messung eines Leiters (in den Figuren 1 und 2 nicht gezeigt) ist der Messadapter 28 über Kontaktanschlüsse 40 mit einem Messgerät (nicht gezeigt) verbindbar.

Es versteht sich, dass bis auf die Leiterplatte 30 sämtliche Komponenten der Adaptiervorrichtung 10, die mit einem zu messenden Leiter im Betrieb in Kontakt gelangen, ein nicht leitfähiges Material aufweisen. In dem gezeigten Ausführungsbeispiel sind diese Komponenten mittels eines Rapid-Prototyping-Verfahrens herstellbar.

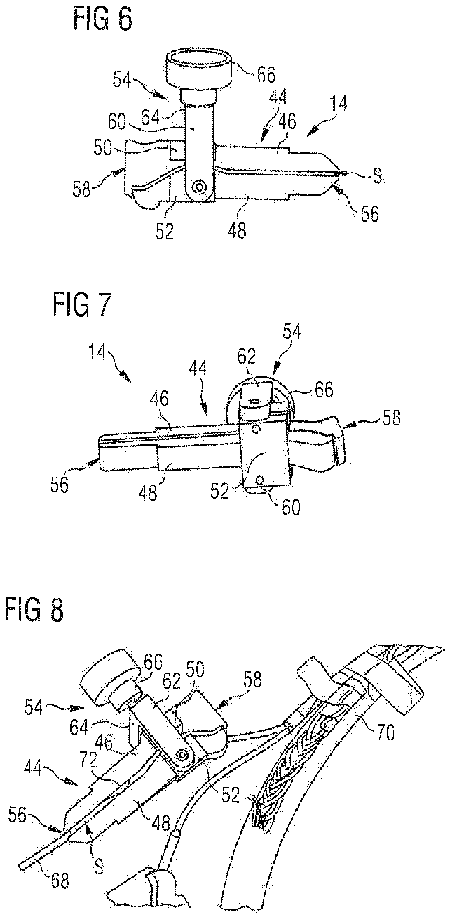

Um wenigstens einen zu messenden Leiter (in den Figuren 1 und 2 nicht gezeigt) für eine Messung vorzubereiten, wird dieser abschnittsweise mittels der Halteklammer 14 aufgenommen und geklemmt. Die Aufnahme eines zu messenden Leiters ist in Bezug auf die Figur 8 näher erläutert. Das abschnittsweise Aufnehmen und Klemmen des zu messenden Leiters mittels der Halteklammer 14 fixiert diesen in seiner Lage und Ausrichtung relativ zu der Halteklammer 14. Dabei wird der Leiter so mittels die Halteklammer 14 aufgenommen, dass sich ein Endabschnitt des Leiters in einem vollständig montierten Zustand der Adaptiervorrichtung 10 in Richtung des Messadapters 28 über die Halteklammer 14 hinaus erstreckt. Die Halteklammer 14 wird gemeinsam mit dem abschnittsweise darin aufgenommenen Leiter an der Aufnahmeeinrichtung 12 angebracht. Dadurch wird die Lage und Ausrichtung der Halteklammer 14 und somit des Leiters relativ zu der Aufnahmeeinrichtung 12 festgelegt. Anschließend wird die Position der Leiterplatte 30 des Messadapters 28 mittels der Mikrometerschrauben 36 in Abhängigkeit der Lage des Leiters so eingestellt, dass sich der Endabschnitt des zu messenden Leiters möglichst genau oberhalb des Kontaktbereichs 32 der Leiterplatte 30 befindet. Zum Kontaktieren des Endabschnitts des Leiters mit dem Kontaktbereich 32 der Leiterplatte 30 wird der Stempel 38 betätigt und in Richtung des Kontaktbereichs 32 verlagert, wodurch der Endabschnitt des Leiters auf den Kontaktbereich 32 gedrückt wird. Dadurch kann sichergestellt werden, dass der Leiter leitend mit der Leiterplatte 30 verbunden wird und sich die ausgebildete Verbindung während der Messung nicht versehentlich löst.

Das präzise und reproduzierbare Festlegen der Lage und Ausrichtung des zu messenden Leiters mittels der Adaptiervorrichtung 10 und das dadurch mögliche Herstellen einer sicheren leitfähigen Verbindung mit einem Messgerät vereinfacht die Probenvorbereitung und ermöglich es, reproduzierbare Messergebnisse zu erzielen.

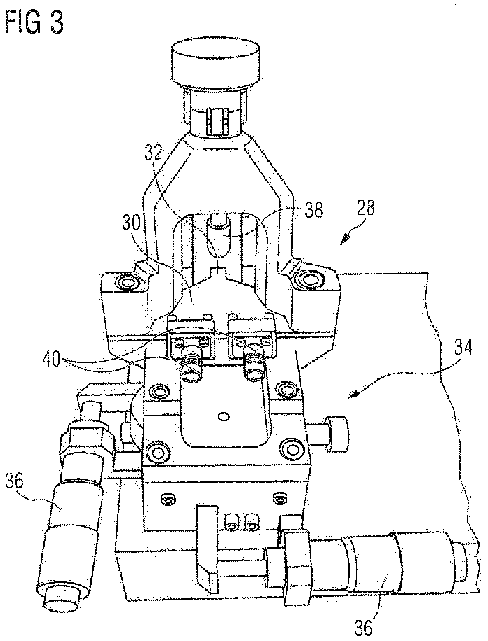

Figur 3 zeigt die Adaptiervorrichtung gemäß den Figuren 1 und 2 in einer weiteren perspektivischen Ansicht, in der beide Mikrometerschrauben 36 des X-Y-Tischs 34 des Messadapters 28 zu erkennen sind. Auch sind in der Darstellung gemäß Figur 3 beide Kontaktanschlüsse 40 des Messadapters 28 zum Verbinden des Messadapters 28 mit einem Messgerät gezeigt.

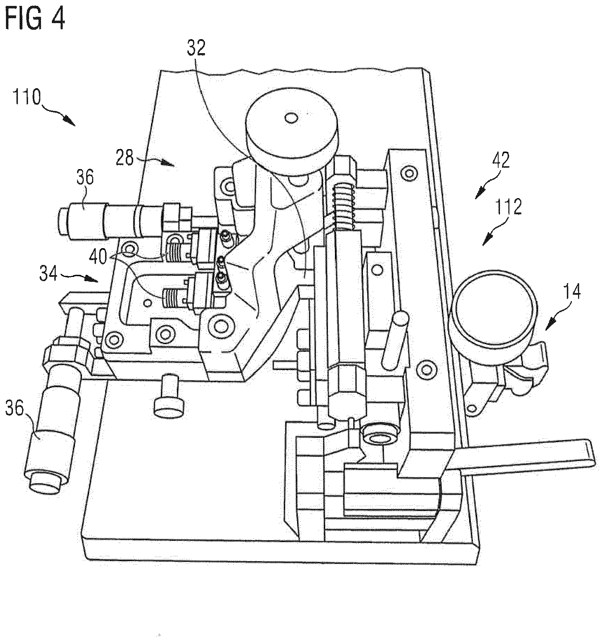

Figur 4 zeigt ein weiteres Ausführungsbeispiel einer Adaptiervorrichtung 110. Die Adaptiervorrichtung 110 gemäß Figur 4 entspricht im Wesentlichen der Adaptiervorrichtung 10 der Figuren 1 bis 3, weshalb vergleichbare bzw. gleiche und gleichwirkende Komponenten und Merkmale mit denselben Bezugszeichen wie in den vorherigen Figuren versehen sind. So entsprechen beispielsweise die Halteklammer und der Messadapter der Adaptiervorrichtung gemäß Figur 4 den entsprechenden Komponenten der Figuren 1 bis 3. Die Komponenten und Merkmale, die in Bezug auf die weiteren Figuren nicht erneut beschrieben sind, ähneln in ihrer Ausbildung und Funktion den entsprechenden Komponenten und Merkmalen der vorherigen Figuren.

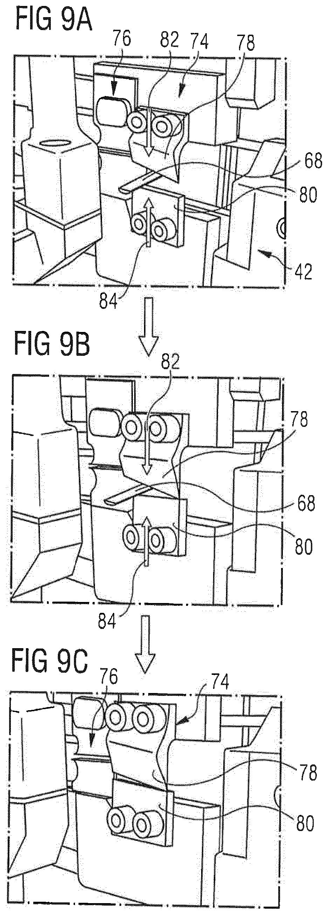

Im Unterschied zu der Adaptiervorrichtung 10 der Figuren 1 bis 3 umfasst die Adaptiervorrichtung 110 der Figur 4 zusätzlich eine Schneid- und Abisoliereinrichtung 42, die fest mit einer Aufnahmeeinrichtung 112 der Adaptiervorrichtung 110 verbunden ist. Genauer gesagt ist die Aufnahmeeinrichtung 112 der Adaptiervorrichtung 110 in der Schneid- und Abisoliereinrichtung 42 integriert. Wie Figur 4 zu entnehmen ist, ist die Schneid- und Abisoliereinrichtung 42 zwischen der Halteklammer 14 und dem Messadapter 28 angeordnet. Die Lage und Ausrichtung der Schneid- und Abisoliereinrichtung 42 relativ zu einer Basis des Messadapters 28 ist in dem gezeigten Beispiel durch eine jeweilige Fixierung der Schneid- und Abisoliereinrichtung 42 und des Messadapters 28 am Untergrund festgelegt. Die Schneid- und Abisoliereinrichtung 42 ist dazu eingerichtet, mittels eines Schneidwerkzeugs (in Figur 4 nicht gezeigt) einen sich über die Halteklammer 14 hinaus erstreckenden Endabschnitt eines von der Halteklammer 14 aufgenommenen und geklemmten Leiters (in Figur 4 ebenfalls nicht gezeigt) auf eine vorbestimmte Länge zuzuschneiben. Ferner umfasst die Schneid- und Abisoliereinrichtung 42 ein Abisolierwerkzeug (in Figur 4 nicht gezeigt), das dazu ausgebildet ist, einen vorbestimmten Bereich des sich über die Halteklammer 14 hinaus erstreckenden Endabschnitts des zu messenden Leiters abzuisolieren. Der Vorgang des Zuschneidens und Abisolierens ist nachstehend in Bezug auf die Figuren 9A-9I näher erläutert.

Die in der Aufnahmeeinrichtung der Adaptiervorrichtung 110 aufgenommene Halteklammer 14 ist in dieser beispielhaften Ausführungsform über die Aufnahmeeinrichtung 112 quer zur Längsachse der Halteklammer 14 relativ zu der Schneid- und Abisoliereinrichtung 42 verlagerbar. Beispielsweise kann eine solche Verlagerbarkeit über ein Schienensystem (in Figur 4 nicht gezeigt) realisiert sein. In einem Beispiel kann eine solche Verlagerbarkeit über an der Halteklammer und der Aufnahmeeinrichtung bzw. der Schneid- und Abisoliereinrichtung ausgebildete Gleitoberflächen realisiert sein. Die Ausrichtung der Halteklammer 14 relativ zu der Schneid- und Abisoliereinrichtung 42 ist trotz dieser Verlagerbarkeit bereits durch ein Einbringen der Halteklammer 14 in die Aufnahmeeinrichtung 112 festgelegt, während die Lage der Halteklammer 14 relativ zu der Schneid- und Abisoliereinrichtung 42 durch das Verlagern der Halteklammer 14 veränderbar ist. Die Halteklammer 14 ist jedoch in verschiedenen Positionen relativ zu der Schneid- und Abisoliereinrichtung 42 fixierbar, um auch die Lage der Halteklammer 14 relativ zu der Schneid- und Abisoliereinrichtung 42 festzulegen. Das Verlagern und feste Positionieren der Halteklammer relativ zu der Schneid- und Abisoliereinrichtung 42 ermöglicht ein reproduzierbares Abisolieren, Zuschneiden und Positionieren eines zu messenden Leiters, was ebenfalls nachstehend in Bezug auf die Figuren 9A-9I näher erläutert ist.

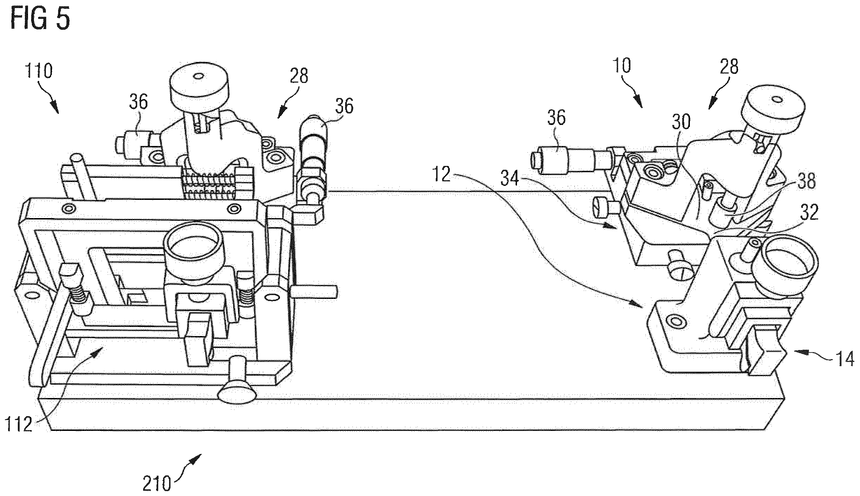

Figur 5 zeigt eine weitere Ausführungsform einer Adaptiervorrichtung 210 zum Positionieren beider Enden wenigstens eines Leiters eines zu messenden Kabels (in Figur 5 nicht gezeigt), die eine Kombination der Adaptiervorrichtungen 10, 110 der Figuren 1 und 4 ist. Mit anderen Worten stellt die Adaptiervorrichtung 210 eine Anordnung dar, die die Adaptiervorrichtung 10 gemäß den Figuren 1 bis 3 zum Positionieren eines Endes des Leiters und die Adaptiervorrichtung 110 gemäß Figur 4 zum Positionieren des anderen Endes des Leiters umfasst. Es versteht sich, dass in weiteren beispielhaften Ausführungsform eine Adaptiervorrichtung zum Positionieren beider Enden wenigstens eines Leiters eines zu messenden Kabels vorgesehen sein kann, die zwei Adaptiervorrichtungen gemäß den Figuren 1 bis 3 oder zwei Adaptiervorrichtungen gemäß Figur 4 umfasst. Auch können mehrere Adaptiervorrichtungen der vorstehend beschriebenen Art vorgesehen sein, um mehrere Leiter eines oder mehrerer zu messender Kabel zu Positionieren.

Die Figuren 6 und 7 zeigen ein Ausführungsbeispiel der Halteklammer 14 in einer Seitenansicht (Figur 6) und einer Untersicht (Figur 7). Die Halteklammer 14 weist einen länglichen Grundkörper 44 mit einem ersten Schenkel 46 und einem zweiten Schenkel 48 auf. Der erste und der zweite Schenkel 46, 48 erstrecken sich in Längsrichtung der Halteklammer 14 abschnittsweise im Wesentlichen parallel zueinander.

Der Grundkörper 44, genauer gesagt jeder der beiden Schenkel 46, 48, umfasst einen Anbringungsabschnitt 50, 52, der den Grundkörper quer zur Längsachse der Halteklammer 14 beidseitig überragt, d.h. der eine größere Breite als der zugehörige Schenkel hat. Der Anbringungsabschnitt 50, 52 dient der Anbringung eines Kraftaufbringungsmechanismus 54, welcher nachstehend näher erläutert ist.

In einem sich von den Anbringungsabschnitten 50, 52 in Richtung eines ersten Endes 56 der Halteklammer 14 erstreckenden ersten Bereich des Grundkörpers 44 haben die beiden Schenkel 46, 48 eine im Wesentlichen konstante Höhe. Die Außenoberfläche des Grundkörpers 44 ist in dem ersten Bereich abschnittsweise komplementär zu einer zugehörigen Aufnahmeeinrichtung (hier nicht gezeigt) ausgebildet und weist in dem gezeigten Ausführungsbeispiel eine rechteckige Gestalt auf.

Im Gegensatz zu dem ersten Bereich weist der erste Schenkel 46 in einem sich von dem Anbringungsabschnitt 50 in Richtung eines zweiten Endes 58 der Halteklammer 14 erstreckenden zweiten Bereich des Grundkörpers 44 eine zunehmende Höhe auf, wobei sich die Höhenerweiterung des ersten Schenkels 46 im Wesentlichen in Richtung des zweiten Schenkels 48 erstreckt. Der zweite Schenkel 48 weist in dem zweiten Bereich des Grundkörpers 44 eine entsprechende Verjüngung auf, sodass sich einander zugewandte Flächen des ersten und zweiten Schenkels 46, 48 auch in dem zweiten Bereich im Wesentlichen parallel zueinander erstrecken.

Der erste und der zweite Schenkel 46, 48 sind geringfügig voneinander beabstandet und bilden so einen Spalt S, um wenigstens einen zu messenden Leiter (in den Figu-ren 6 und 7 nicht gezeigt) abschnittsweise zwischen sich aufzunehmen. Durch die sich erweiternde Höhe des ersten Schenkels 46 und die entsprechende Verjüngung des zweiten Schenkels 48 hat der Spalt S in dem zweiten Bereich einen kurvenförmigen Verlauf. Dies ist vorteilhaft für die Fixierung des zu messenden Leiters zwischen den Schenkeln 46, 48.

Die beiden Schenkel 46, 48 sind in der gezeigten Ausführungsform relativ zueinander verlagerbar, wodurch die Höhe des Spalts S zur Aufnahme eines zu messenden Leiters vergrößerbar oder zum Klemmen des zu messenden Leiters verringerbar ist. Um den Spalt S zu verringern und dadurch einen zwischen den Schenkeln 46, 48 aufgenommenen Leiter zu klemmen, kann mittels des Kraftaufbringungsmechanismus 54 auf die Schenkel 46, 48 eingewirkt werden.

In dem gezeigten Beispiel umfasst der Kraftaufbringungsmechanismus 54 einen U-förmigen Bügel mit zwei zueinander parallelen Bügelschenkeln 60, 62 und einem die Bügelschenkel 60, 62 verbindenden Bügelsteg 64. Die Bügelschenkel 60, 62 sind jeweils schwenkbar mit dem zweiten Schenkel 48 verbunden, wobei der erste Schenkel 46 zwischen dem Bügelsteg 64 und dem zweiten Schenkel 48 angeordnet ist. Der Bügelsteg 64 umfasst eine Gewindebohrung (nicht gezeigt), in die eine Schraube 66 einschraubbar ist, um auf den ersten Schenkel 46 kraftaufbringend einzuwirken. Durch die Anbringung der Bügelschenkel 60, 62 an dem zweiten Schenkel 48 der Halteklammer 14 und die Krafteinwirkung auf den ersten Schenkel 46 der Halteklammer 14, werden die beiden Schenkel 46, 48 aufeinander zu bewegt bzw. zusammengedrückt, wodurch ein dazwischen aufgenommener Leiter festgeklemmt wird.

Figur 8 zeigt die Halteklammer 14 gemäß den Figuren 6 und 7 mit einem abschnittsweise darin aufgenommenen und geklemmten Leiter 68 eines zu messenden Kabels 70.

Der Leiter 68 wird zum Positionieren mittels der Halteklammer 14 an dem zweiten Ende 58 der Halteklammer 14 in diese eingebracht, entlang des Spalts S durch den Grundkörper 44 der Halteklammer 14 hindurch geführt und tritt an dem ersten Ende 56 der Halteklammer 14 wieder aus dieser aus. Anschließend wird der Kraftaufbringungsmechanismus 54 durch ein Einschrauben der Schraube 66 betätigt. Dadurch wird der Leiter 68 zwischen den beiden Schenkel 46, 48, wie zuvor beschrieben, geklemmt. Wie aus Figur 8 zu erkennen ist, weist der erste Schenkel 46 in dem ersten Bereich des Grundkörpers 44 an einer dem zweiten Schenkel 48 zugewandten Fläche, d.h. im Bereich des Spalts S, einen Vorsprung 72 auf. Dieser unterstützt zusätzlich die Fixierung bzw. das Klemmen des Leiters 68 zwischen den Schenkeln 46, 48 der Halteklammer 14.

In einem nicht dargestellten Ausführungsbeispiel kann an der Halteklammer ein Abschnitt eines Schienensystems befestigt oder ausgebildet sein, über den die Halteklammer mit einem an der Aufnahmeeinrichtung vorgesehenen komplementären Abschnitt des Schienensystems anbringbar ist.

Die Figuren 9A bis 9I zeigen einen Schneid- und Abisoliervorgang mittels der Schneid- und Abisoliereinrichtung 42 der Adaptiervorrichtung 110 gemäß Figur 4, die ein Schneidwerkzeug 74 und ein Abisolierwerkzeug 76 umfasst. Das Schneidwerkzeug 74 und das Abisolierwerkzeug 76 sind in einer Richtung quer zur Längsachse der Halteklammer 14 benachbart zueinander angeordnet.

Das Schneidwerkzeug 74 umfasst zwei bewegbare, einander gegenüberliegende Schneidflächen 78, 80, die in dem gezeigten Ausführungsbeispiel in Richtung der Pfeile 82, 84 automatisch aufeinander zu bewegbar sind, um den zwischen den Schneidflächen 78, 80 angeordneten Endabschnitt des Leiters 68 auf eine vorbestimmte Länge zuzuschneiden. Hierzu wird der zu messende Leiter 68, der in der Halteklammer 14 fixiert ist, mittels der Halteklammer 14 im Bereich des Schneidwerkzeugs 74 in die Aufnahmeeinrichtung der Schneid- und Abisoliereinrichtung 42 angeordnet. Dadurch erstreckt sich der zu messenden Leiter 68 zwischen den Schneidflächen 78, 80 des Schneidwerkzeugs 74 hindurch, wobei der Leiter 68 durch die Halteklammer 14 in seiner Lage und Ausrichtung festgelegt ist.

Die Schneidflächen 78, 80 sind zu Beginn des Schneidvorgangs sowie beim Einbringen des Leiters 68 geöffnet, d.h. voneinander beabstandet (siehe Figur 9A). Zum Zuschneiden des Endabschnitts des Leiters 68 wird das Schneidwerkzeug 64 betätigt, wodurch die Schneidflächen 78, 80 in dem gezeigten Beispiel horizontal aufeinander zu bewegt werden (siehe Figur 9B). Wie aus Figur 9C zu erkennen ist, sind die Schneidflächen 78, 80 in Richtung der Längsachse der Halteklammer 14 relativ zueinander geringfügig versetzt, sodass sie bei einer vollständigen Betätigung des Schneidwerkzeugs 74 aneinander vorbei gleiten. Dadurch wird der sich zwischen den Schneidflächen 78, 80 hindurch erstreckende Endabschnitt des Leiters 68 durchtrennt. Die Länge des zugeschnittenen Endabschnitts des Leiters 68 entspricht anschließend dem Abstand zwischen dem ersten Ende 56 der Halteklammer 14, an dem der Leiter 68 aus der Halteklammer 14 austritt, und den Schneidflächen 78, 80 des Schneidwerkzeugs 74. Dieser Abstand kann in verschiedenen Ausführungsformen der Adaptiervorrichtung variabel einstellbar sein, beispielsweise durch ein Einstellen und Verändern der Position der Halteklammer, der Aufnahmeeinrichtung und/oder der Schneidflächen.

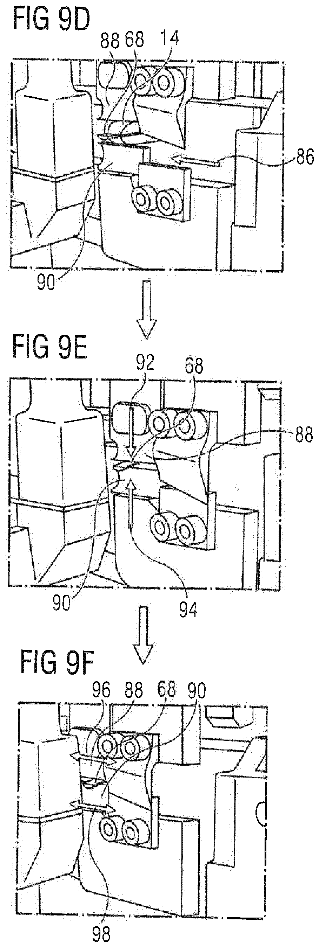

Im Anschluss an den Schneidvorgang wird das Schneidwerkzeug 74 durch ein Verlagern der Schneidflächen 78, 80 in einander entgegengesetzte Richtungen geöffnet (siehe Figur 9D). Ferner wird der Leiter 68 mittels der Halteklammer 14 in Richtung des Pfeils 86 in den Bereich des Abisolierwerkzeugs 76 verlagert. Das Abisolierwerkzeug 76 umfasst zwei bewegbare, einander gegenüberliegende Abisolierflächen 88, 90 mit Schneidkanten, die in dem gezeigten Ausführungsbeispiel in Richtung der Pfeile 92, 94 automatisch aufeinander zu bewegbar sind, um den zwischen den Abisolierflächen 88, 90 angeordneten (zugeschnittenen) Endabschnitt des Leiters 68 abzuisolieren.

Hierzu werden die Abisolierflächen 88, 90 zunächst aufeinander zu bewegt, sodass sie den Endabschnitt des Leiters 68 kontaktieren (siehe Figur 9E). Anschließend werden die den Endabschnitt des Leiters 68 kontaktierenden Abisolierflächen 88, 90 relativ zu dem Leiter 68 in Figur 9F in einer Richtung quer zur Richtung der Längsachse der Halteklammer 14 wenigstens einmal reziprok bewegt (siehe Pfeile 96, 98), wodurch die Isolierung des Endabschnitts des Leiters 68 abschnittsweise eingeschnitten wird. Die reziproke Relativbewegung zwischen den Abisolierflächen 88, 90 und dem Endabschnitt des Leiters 68 bzw. der Halteklammer 14 wird in dem gezeigten Ausführungsbeispiel durch eine Verlagerung der gesamten Schneid- und Abisoliereinrichtung 42 relativ zu der Halteklammer 14 erreicht. In weiteren Ausführungsformen ist es jedoch möglich, das Abisolierwerkzeug 76 ohne das Schneidwerkzeug 74, die Abisolierflächen 88, 90 und/oder die Halteklammer 14 für eine solche Relativbewegung zu verlagern.

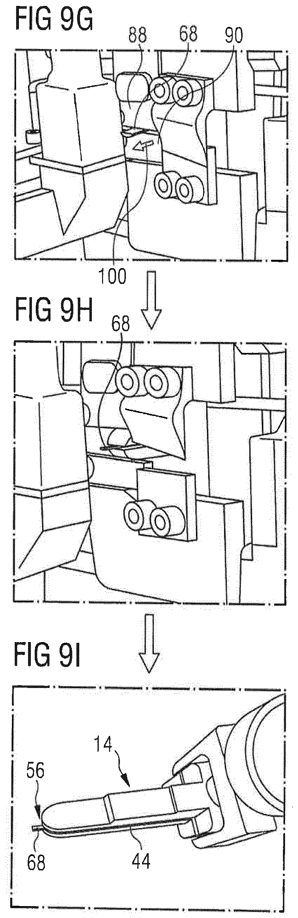

Im Anschluss an das Einschneiden der Abisolierung des Endabschnitts des Leiters 68 werden die den Endabschnitt des Leiters 68 weiterhin kontaktierenden Abisolierflächen 88, 90 relativ zu dem Leiter 68 in einer Richtung entlang der Längsachse der Halteklammer 14 (siehe Pfeile 100) bewegt (siehe Figur 9G). Dadurch wird ein Bereich der Abisolierung zwischen dem Ende des Endabschnitts des Leiters 68 und dem erzeugten Einschnitt von dem Leiter 68 abgezogen bzw. entfernt. Die Länge des abzuisolierenden Bereichs des Endabschnitts des Leiters 68 entspricht anschließend dem Abstand zwischen dem ersten Ende des Endabschnitts des Leiters 68 und den Schneidkanten der Abisolierflächen 88, 90 des Abisolierwerkzeugs 76. Dieser Abstand kann in verschiedenen Ausführungsformen der Adaptiervorrichtung variabel einstellbar sein, beispielsweise durch ein Einstellen und Verändern der Position der Halteklammer, der Aufnahmeeinrichtung und/oder der Abisolierflächen.

Wie aus Figur 9H ersichtlich ist, wird das Abisolierwerkzeug 76 nach dem Abisoliervorgang durch ein Verlagern der Abisolierflächen 88, 90 in einander entgegengesetzte Richtungen geöffnet. Somit steht der definiert zugeschnittene und abisolierte Endabschnitt des Leiters 68 für eine Kontaktierung mit der Leiterplatte des Messadapters zur Verfügung.

Figur 9I zeigt einen in der Halteklammer 14 aufgenommenen und geklemmten Leiter 68, der gemäß der voranstehenden Erläuterung zugeschnitten und abisoliert wurde. Durch ein Einstellen der vorstehend beschriebenen relativen Abstände des Schneidwerkzeugs, des Abisolierwerkzeugs und der Halteklammer können die Länge des sich über das Ende der Halteklammer hinaus erstreckende Endabschnitts des Leiters und die Länge des abisolierten Bereichs des Endabschnitts des Leiters präzise und reproduzierbar sowie automatisiert angepasst werden.

## Patentansprüche

1. Adaptiervorrichtung (10, 110, 210) zum Positionieren wenigstens eines Leiters (68), beispielsweise eines Leiterpaares, eines zu messenden Kabels (70), die eine Aufnahmeeinrichtung (112) und eine an der Aufnahmeeinrichtung (112) anbringbare Halteklammer (14) umfasst, wobei ein Anbringen der Halteklammer (14) an der Aufnahmeeinrichtung (112) die Halteklammer (14) in ihrer Lage und Ausrichtung relativ zu der Aufnahmeeinrichtung (112) festlegt, und wobei die Halteklammer (14) dazu ausgebildet ist, den wenigstens einen Leiter (68) des zu messenden Kabels (70) abschnittsweise aufzunehmen und zu klemmen, um diesen in seiner Lage und Ausrichtung relativ zu der Halteklammer (14) zu fixieren, so dass sich ein Endabschnitt des wenigstens einen Leiters (68) über die Halteklammer (14) hinaus erstreckt, und
**dadurch gekennzeichnet, dass** die Adaptiervorrichtung (10, 110, 210) eine fest mit der Aufnahmeeinrichtung (112) verbundene Schneid- und Abisoliereinrichtung (42) umfasst, wobei die Aufnahmeeinrichtung (112) in die Schneid- und Abisoliereinrichtung (42) integriert ist, wobei die Schneid- und Abisoliereinrichtung (42) ferner
- ein Schneidwerkzeug (74) aufweist, das dazu ausgebildet ist, den sich über die Halteklammer (14) hinaus erstreckenden Endabschnitt des wenigstens einen von der Halteklammer (14) aufgenommenen und geklemmten Leiters (68) auf eine vorbestimmte Länge zuzuschneiden, und/oder
- ein Abisolierwerkzeug (76) aufweist, das dazu ausgebildet ist, einen vorbestimmten Bereich des sich über die Halteklammer (14) hinaus erstreckenden Endabschnitts des wenigstens einen von der Halteklammer (14) aufgenommenen und geklemmten Leiters (68) abzuisolieren,
wobei die in der Aufnahmeeinrichtung (112) der Adaptiervorrichtung (10, 110, 210) aufgenommene Halteklammer (14) über die Aufnahmeeinrichtung (112) relativ zu der Schneid- und Abisoliereinrichtung (42) verlagerbar und in verschiedenen Positionen relativ zu der Schneid- und Abisoliereinrichtung (42) fixierbar ist, während die Ausrichtung der Halteklammer (14) relativ zu der Schneid- und Abisoliereinrichtung (42) festgelegt ist.

2. Adaptiervorrichtung (10, 110, 210) nach Anspruch 1, wobei die Halteklammer (14) lösbar an der Aufnahmeeinrichtung (112) anbringbar ist.

3. Adaptiervorrichtung (10, 110, 210) nach Anspruch 1 oder 2, wobei die Aufnahmeeinrichtung (112) und die Halteklammer (14) zumindest abschnittsweise eine zueinander komplementäre Gestalt aufweisen, um die Halteklammer (14) formschlüssig an der Aufnahmeeinrichtung (112) anzubringen.

4. Adaptiervorrichtung (10, 110, 210) nach einem der vorangehenden Ansprüche, wobei die Aufnahmeeinrichtung (112) einen Aufnahmekörper (18) mit einer Aufnahmeausnehmung (16) aufweist, durch die sich die Halteklammer (14) in einem an der Aufnahmeeinrichtung (112) angebrachten Zustand hindurch erstreckt, so dass die Halteklammer (14) den Aufnahmekörper (18) an einander entgegengesetzten Seiten des Aufnahmekörpers (18) überragt.

5. Adaptiervorrichtung (10, 110, 210) nach einem der vorangehenden Ansprüche, die ferner einen mit einem Messgerät verbindbaren Messadapter (28) umfasst, der aufweist:
- eine Leiterplatte (30) mit einem Kontaktbereich (32) zum Kontaktieren des Endabschnitts des wenigstens einen Leiters (68), und
- einen verlagerbaren Stempel (38), der dazu ausgebildet ist, durch Betätigung den Endabschnitt des wenigstens einen Leiters (68) auf den Kontaktbereich (32) der Leiterplatte (30) zu drücken.

6. Adaptiervorrichtung (10, 110, 210) nach Anspruch 5, wobei die Leiterplatte (30) des Messadapters (28) auf einem X-Y-Tisch (34) mit Mikrometerschrauben (36) montiert ist und wobei die Lage der Leiterplatte (30) relativ zu dem Endabschnitt des wenigstens einen Leiters (68) durch Einstellen der Mikrometerschrauben (36) anpassbar ist.

7. Halteklammer (14) zum Positionieren wenigstens eines Leiters (68), beispielsweise eines Leiterpaares, eines zu messenden Kabels (70), die dazu ausgebildet ist, den wenigstens einen Leiter (68) des zu messenden Kabels (70) abschnittsweise aufzunehmen und zu klemmen, um diesen in seiner Lage und Ausrichtung relativ zu der Halteklammer (14) zu fixieren, so dass sich ein Endabschnitt des wenigstens einen Leiters (68) über die Halteklammer (14) hinaus erstreckt,
wobei die Halteklammer (14) einen länglichen Grundkörper (44) aufweist, der einen ersten Schenkel (46) und einen zweiten Schenkel (48) umfasst, die sich entlang einer Längsachse der Halteklammer (14) zumindest abschnittsweise im Wesentlichen parallel zueinander erstrecken und voneinander beabstandet sind, um den wenigstens einen Leiter (68) zumindest abschnittsweise zwischen dem ersten und dem zweiten Schenkel (46, 48) aufzunehmen,
wobei der erste Schenkel (46) und der zweite Schenkel (48) zumindest abschnittsweise relativ zueinander verlagerbar sind,
wobei die Halteklammer (14) einen Kraftaufbringungsmechanismus (54) umfasst, der dazu eingerichtet ist, eine Kraft auf den ersten und den zweiten Schenkel (46, 48) aufzubringen, die dazu eingerichtet ist, die Schenkel (46, 48) aufeinander zu zubewegen, um den zwischen diesen angeordneten wenigstens einen Leiter (68) festzuklemmen,
**dadurch gekennzeichnet, dass** der Kraftaufbringungsmechanismus (54) einen im Wesentlichen U-förmigen Bügel mit zwei zueinander parallelen Bügelschenkeln (60, 62) und einem die Bügelschenkel (60, 62) verbindenden Bügelsteg (64) umfasst, wobei die Bügelschenkel (60, 62) jeweils fest oder schwenkbar mit dem zweiten Schenkel (48) der Halteklammer (14) verbunden sind und der erste Schenkel (46) der Halteklammer (14) zwischen dem Bügelsteg (64) und dem zweiten Schenkel (48) angeordnet ist.

8. Halteklammer (14) nach Anspruch 7, wobei der erste und/oder der zweite Schenkel (46, 48) einen Vorsprung (72) aufweist, der sich in Richtung des jeweils anderen Schenkels (46, 48) erstreckt und dazu ausgebildet ist, auf den wenigstens einen Leiter (68) einzuwirken, um diesen zwischen dem Vorsprung (72) und dem jeweils anderen Schenkel (46, 48) zu klemmen.

9. Halteklammer (14) nach Anspruch 7 oder 8, wobei der erste Schenkel (46) und der zweite Schenkel (48) an einem Ende (58) der Halteklammer (14), beispielsweise schwenkbar, miteinander verbunden sind und wobei die Halteklammer (14) an diesem Ende eine Einführöffnung zum Einführen des wenigstens einen Leiters (68) umfasst.

10. Halteklammer (14) nach einem der Ansprüche 7 bis 9, wobei der Bügelsteg (64) eine Gewindebohrung aufweist, in die eine Schraube (66) einschraubbar ist, um auf den ersten Schenkel (46) der Halteklammer (14) kraftaufbringend einzuwirken.

11. Halteklammer (14) nach einem der Ansprüche 7 bis 10, wobei der Grundkörper (40) der Halteklammer (14) mittels eines Rapid-Prototyping-Verfahrens, beispielsweise mittels eines 3D-Druck-Verfahrens, herstellbar ist.

12. Verfahren zum Positionieren wenigstens eines Leiters (68) eines zu messenden Kabels (70)mittels einer Adaptiervorrichtung (10, 110, 210) nach einem der Ansprüche 1 bis 6, wobei das Verfahren die Schritte umfasst:
- abschnittsweises Aufnehmen des wenigstens einen Leiters (68) des zu messenden Kabels (70) mittels einer Halteklammer (14), so dass sich ein Endabschnitt des wenigstens einen Leiters (68) über die Halteklammer (14) hinaus erstreckt;
- Klemmen des wenigstens einen Leiters (68) mittels der Halteklammer (14), wodurch dieser in seiner Lage und Ausrichtung relativ zu der Halteklammer (14) fixiert wird;
- Anbringen der Halteklammer (14) an einer Aufnahmeeinrichtung, wodurch die Halteklammer (14) in ihrer Lage und Ausrichtung relativ zu der Aufnahmeeinrichtung (112) fixiert wird,
wobei das Verfahren ferner wenigstens einen der Schritte umfasst:
- automatisches Zuschneiden des sich über die Halteklammer (14) hinaus erstreckenden Endabschnitts des wenigstens einen von der Halteklammer (14) aufgenommenen und geklemmten Leiters (68) auf eine vorbestimmte Länge mittels eines Schneidwerkzeugs (74) einer Schneid- und Abisoliereinrichtung (42); und
- automatisches Abisolieren eines vorbestimmten Bereichs des sich über die Halteklammer (14) hinaus erstreckenden Endabschnitts des wenigstens einen von der Halteklammer (14) aufgenommenen und geklemmten Leiters (68) mittels eines Abisolierwerkzeugs (76) der Schneid- und Abisoliereinrichtung (42).

## Claims

1. An adapter device (10, 110, 210) for positioning at least one conductor (68), for example a conductor pair, of a cable (70) to be measured, which adapter device comprises a receiving device (112) and a holding clamp (14) which can be attached to the receiving device (112), wherein attaching the holding clamp (14) to the receiving device (112) fixes the holding clamp (14) in its position and orientation relative to the receiving device (112), and wherein the holding clamp (14) is configured to receive and clamp part of the at least one conductor (68) of the cable (70) to be measured in order to fix the conductor in its position and orientation relative to the holding clamp (14), so that an end portion of the at least one conductor (68) extends beyond the holding clamp (14), and
**characterized in that** the adapter device (10, 110, 210) comprises a cutting and stripping device (42) which is fixedly connected to the receiving device (112), wherein the receiving device (112) is integrated into the cutting and stripping device (42), wherein the cutting and stripping device (42) further
- has a cutting tool (74) which is configured to cut the end portion, extending beyond the holding clamp (14), of the at least one conductor (68) received and clamped by the holding clamp (14) to a predetermined length, and/or
- has a stripping tool (76) which is configured to strip a predetermined region of the end portion, extending beyond the holding clamp (14), of the at least one conductor (68) received and clamped by the holding clamp (14)
wherein the holding clamp (14), which is received in the receiving device (112) of the adapter device (10, 110, 210), is displaceable by the receiving device (112) relative to the cutting and stripping device (42) and can be fixed in different positions relative to the cutting and stripping device (42), while the orientation of the holding clamp (14) relative to the cutting and stripping device (42) is fixed.

2. The adapter device (10, 110, 210) as claimed in claim 1, wherein the holding clamp (14) can be releasably attached to the receiving device (112).

3. The adapter device (10, 110, 210) as claimed in claim 1 or 2, wherein the receiving device (12) and the holding clamp (14) have a mutually complementary shape at least in part, in order to attach the holding clamp (14) to the receiving device (12) in an interlocking manner.

4. The adapter device (10, 110, 210) as claimed in any one of the preceding claims, wherein the receiving device (12) has a receiving body (18) with a receiving recess (16) through which the holding clamp (14) extends in a state in which it is attached to the receiving device (12), so that the holding clamp (14) projects beyond the receiving body (18) on opposite sides of the receiving body (18).

5. The adapter device (10, 110, 210) as claimed in any one of the preceding claims, which further comprises a measuring adapter (28) which can be connected to a measuring instrument, which measuring adapter comprises:
- a circuit board (30) having a contact region (32) for contacting the end portion of the at least one conductor (68), and
- a displaceable plunger (38) which is configured, as a result of being actuated, to press the end portion of the at least one conductor (68) onto the contact region (32) of the circuit board (30).

6. The adapter device (10, 110, 210) as claimed in claim 5, wherein the circuit board (30) of the measuring adapter (28) is mounted on an X-Y table (34) with micrometer screws (36), and wherein the position of the circuit board (30) relative to the end portion of the at least one conductor (68) is adjustable by adjustment of the micrometer screws (36).

7. A holding clamp (14) for positioning at least one conductor (68), for example a conductor pair, of a cable (70) to be measured, which holding clamp is configured to receive and clamp part of the at least one conductor (68) of the cable (70) to be measured in order to fix the conductor in its position and orientation relative to the holding clamp (14), so that an end portion of the at least one conductor (68) extends beyond the holding clamp (14),
wherein the holding clamp (14) has an elongate base body (44) which comprises a first leg (46) and a second leg (48) which extend at least in part substantially parallel to one another along a longitudinal axis of the holding clamp (14) and are spaced apart from one another in order to receive at least part of the at least one conductor (68) between the first and the second leg (46, 48),
wherein the first leg (46) and the second leg (48) are displaceable relative to one another at least in part,
wherein the holding clamp (14) comprises a force application mechanism (54) which is configured to apply a force on the first and the second leg (46, 48), which is configured to move the legs (46, 48) towards one another, in order to clamp the at least one conductor (68) firmly between the first and the second leg (46, 48),
**characterized in that** the force application mechanism (54) comprises a substantially U-shaped stirrup with two mutually parallel stirrup legs (60, 62) and a stirrup crosspiece (64) connecting the stirrup legs (60, 62), wherein the stirrup legs (60, 62) are each fixedly or pivotably connected to the second leg (48) of the holding clamp (14) and the first leg (46) of the holding clamp (14) is arranged between the stirrup crosspiece (64) and the second leg (48).

8. The holding clamp (14) as claimed in claim 7, wherein the first and/or the second leg (46, 48) has a projection (72) which extends in the direction towards the respective other leg (46, 48) and is configured to act on the at least one conductor (68) in order to clamp it between the projection (72) and the respective other leg (46, 48).

9. The holding clamp (14) as claimed in claim 7 or 8, wherein the first leg (46) and the second leg (48) are connected together, for example pivotably, at one end (58) of the holding clamp (14), and wherein the holding clamp (14) comprises at that end an insertion opening for insertion of the at least one conductor (68).

10. The holding clamp (14) as claimed in any one of claims 7 to 9, wherein the stirrup crosspiece (60) has a threaded bore into which a screw (66) can be screwed in order to act in a force-applying manner on the first leg (46) of the holding clamp (14).

11. The holding clamp (14) as claimed in any one of claims 7 to 10, wherein the base body (40) of the holding clamp (14) can be produced by means of a rapid prototyping method, for example by means of a 3D printing method.

12. A method for positioning at least one conductor (68) of a cable (70) to be measured by means of an adapter device (10, 110, 210) as claimed in any one of claims 1 to 6, which method comprises the steps:
- receiving part of the at least one conductor (68) of the cable (70) to be measured by means of a holding clamp (14), so that an end portion of the at least one conductor (68) extends beyond the holding clamp (14);
- clamping the at least one conductor (68) by means of the holding clamp (14), whereby the conductor is fixed in its position and orientation relative to the holding clamp (14);
- attaching the holding clamp (14) to a receiving device, whereby the holding clamp (14) is fixed in its position and orientation relative to the receiving device (12), wherein the method further comprises at least one of the steps:
- automatically cutting the end portion, extending beyond the holding clamp (14), of the at least one conductor (68) received and clamped by the holding clamp (14) to a predetermined length by means of a cutting tool (74) of a cutting and stripping device (42); and
- automatically stripping a predetermined region of the end portion, extending beyond the holding clamp (14), of the at least one conductor (68) received and clamped by the holding clamp (14) by means of a stripping tool (76) of the cutting and stripping device (42).

## Revendications

1. Dispositif adaptateur (10, 110, 210) pour positionner au moins un conducteur (68), par exemple une paire de conducteurs, d'un câble (70) à mesurer, qui comprend un moyen de réception (112) et une pince de retenue (14) pouvant être montée sur le moyen de réception (112), dans lequel un montage de la pince de retenue (14) sur le moyen de réception (112) fixe la pince de retenue (14) dans sa position et son orientation par rapport au moyen de réception (112), et dans lequel la pince de retenue (14) est conçue pour recevoir et serrer sur certaines parties ledit au moins un conducteur (68) du câble (70) à mesurer, afin de le fixer dans sa position et son orientation par rapport à la pince de retenue (14) de telle sorte qu'une partie d'extrémité dudit au moins un conducteur (68) s'étende au-delà de la pince de retenue (14), et
**caractérisé en ce que** le dispositif adaptateur (10, 110, 210) comprend un moyen de coupe et de dénudage (42) relié de manière fixe au moyen de réception (112), dans lequel le moyen de réception (112) est intégré dans le moyen de coupe et de dénudage (42), le moyen de coupe et de dénudage (42) comprenant en outre
- un outil de coupe (74) conçu pour couper à une longueur prédéterminée la partie d'extrémité s'étendant au-delà de la pince de retenue (14) dudit au moins un conducteur (68) reçu et serré par la pince de retenue (14), et/ou
- un outil de dénudage (76) conçu pour dénuder une zone prédéterminée de la partie d'extrémité s'étendant au-delà de la pince de retenue (14) dudit au moins un conducteur (68) reçu et serré par la pince de retenue (14),
dans lequel la pince de retenue (14) reçue dans le moyen de réception (112) du dispositif adaptateur (10, 110, 210) peut être déplacée par rapport au moyen de coupe et de dénudage (42) par l'intermédiaire du moyen de réception (112) et peut être fixée dans différentes positions par rapport au moyen de coupe et de dénudage (42) tandis que l'orientation de la pince de retenue (14) par rapport au moyen de coupe et de dénudage (42) est fixée.

2. Dispositif adaptateur (10, 110, 210) selon la revendication 1, dans lequel la pince de retenue (14) peut être montée de manière amovible sur le moyen de réception (112).

3. Dispositif adaptateur (10, 110, 210) selon la revendication 1 ou 2, dans lequel le moyen de réception (112) et la pince de retenue (14) présentent au moins sur certaines parties une forme complémentaire l'un à l'autre, afin de monter la pince de retenue (14) par complémentarité de forme sur le moyen de réception (112).

4. Dispositif adaptateur (10, 110, 210) selon l'une des revendications précédentes, dans lequel le moyen de réception (112) présente un corps de réception (18) avec un évidement de réception (16) à travers lequel s'étend la pince de retenue (14) dans un état monté sur le moyen de réception (112), de telle sorte que la pince de retenue (14) dépasse du corps de réception (18) sur des côtés opposés du corps de réception (18).

5. Dispositif adaptateur (10, 110, 210) selon l'une des revendications précédentes, comportant en outre un adaptateur de mesure (28) pouvant être relié à un appareil de mesure, comprenant :
- une carte de circuit imprimé (30) comportant une zone de contact (32) pour entrer en contact avec la partie d'extrémité dudit au moins un conducteur (68), et
- un poinçon déplaçable (38) conçu pour presser, par actionnement, la partie d'extrémité dudit au moins un conducteur (68) sur la zone de contact (32) de la carte de circuit imprimé (30).

6. Dispositif adaptateur (10, 110, 210) selon la revendication 5, dans lequel la carte de circuit imprimé (30) de l'adaptateur de mesure (28) est montée sur une table X-Y (34) avec des vis micrométriques (36) et dans lequel la position de la carte de circuit imprimé (30) par rapport à la partie d'extrémité dudit au moins un conducteur (68) peut être ajustée en réglant les vis micrométriques (36).

7. Pince de retenue (14) pour positionner au moins un conducteur (68), par exemple une paire de conducteurs, d'un câble (70) à mesurer, qui est conçue pour recevoir et serrer sur certaines parties ledit au moins un conducteur (68) du câble (70) à mesurer, afin de le fixer dans sa position et son orientation par rapport à la pince de retenue (14) de telle sorte qu'une partie d'extrémité dudit au moins un conducteur (68) s'étende au-delà de la pince de retenue (14),
dans laquelle la pince de retenue (14) comprend un corps de base allongé (44) comprenant une première branche (46) et une deuxième branche (48) qui s'étendent le long d'un axe longitudinal de la pince de retenue (14) sensiblement parallèlement l'une à l'autre au moins sur certaines parties et qui sont espacées l'une de l'autre afin de recevoir ledit au moins un conducteur (68) au moins sur certaines parties entre la première et la deuxième branche (46, 48),
dans laquelle la première branche (46) et la deuxième branche (48) peuvent être déplacées l'une par rapport à l'autre au moins sur certaines parties,
dans laquelle la pince de retenue (14) comprend un mécanisme d'application de force (54) qui est conçu pour appliquer sur la première et la deuxième branche (46, 48) une force conçue pour rapprocher les branches (46, 48) l'une de l'autre afin de serrer ledit au moins un conducteur (68) disposé entre elles,
**caractérisé en ce que** le mécanisme d'application de force (54) comprend un étrier sensiblement en forme de U avec deux branches d'étrier (60, 62) parallèles l'une à l'autre et une barrette d'étrier (64) reliant les branches d'étrier (60, 62), les branches d'étrier (60, 62) étant chacune reliées de manière fixe ou pivotante à la deuxième branche (48) de la pince de retenue (14) et la première branche (46) de la pince de retenue (14) étant disposée entre la barrette d'étrier (64) et la deuxième branche (48).

8. Pince de retenue (14) selon la revendication 7, dans laquelle la première et/ou la deuxième branche (46, 48) présente une saillie (72) qui s'étend en direction de l'autre branche respective (46, 48) et qui est conçue pour agir sur ledit au moins un conducteur (68) afin de le serrer entre la saillie (72) et l'autre branche respective (46, 48).

9. Pince de retenue (14) selon la revendication 7 ou 8, dans laquelle la première branche (46) et la deuxième branche (48) sont reliées l'une à l'autre, par exemple de manière pivotante, à une extrémité (58) de la pince de retenue (14), et dans laquelle la pince de retenue (14) comprend à cette extrémité une ouverture d'insertion pour l'insertion dudit au moins un conducteur (68).

10. Pince de retenue (14) selon l'une des revendications 7 à 9, dans laquelle la barrette d'étrier (64) comprend un trou taraudé dans lequel une vis (66) peut être vissée afin agir par application d'une force sur la première branche (46) de la pince de retenue (14).

11. Pince de retenue (14) selon l'une des revendications 7 à 10, dans laquelle le corps de base (40) de la pince de retenue (14) peut être fabriqué au moyen d'un procédé de prototypage rapide, par exemple au moyen d'un procédé d'impression 3D.

12. Procédé pour positionner au moins un conducteur (68) d'un câble (70) à mesurer au moyen d'un dispositif adaptateur (10, 110, 210) selon l'une des revendications 1 à 6, le procédé comprenant les étapes de :
- réception au moins sur certaines parties dudit au moins un conducteur (68) du câble (70) à mesurer au moyen d'une pince de retenue (14) de telle sorte qu'une partie d'extrémité dudit au moins un conducteur (68) s'étende au-delà de la pince de retenue (14) ;
- serrage dudit au moins un conducteur (68) au moyen de la pince de retenue (14), de sorte que celui-ci soit fixé dans sa position et son orientation par rapport à la pince de retenue (14) ;
- montage de la pince de retenue (14) sur un moyen de réception, de sorte que la pince de retenue (14) soit fixée dans sa position et son orientation par rapport au moyen de réception (112),
le procédé comprenant en outre au moins l'une des étapes de :
- coupe automatique à une longueur prédéterminée, au moyen d'un outil de coupe (74) d'un moyen de coupe et de dénudage (42), de la partie d'extrémité s'étendant au-delà de la pince de retenue (14) dudit au moins un conducteur (68) reçu et serré par la pince de retenue (14) ; et
- dénudage automatique d'une zone prédéterminée de la partie d'extrémité s'étendant au-delà de la pince de retenue (14) dudit au moins un conducteur (68) reçu et serré par la pince de retenue (14) au moyen d'un outil de dénudage (76) du moyen de coupe et de dénudage (42).
